# EUROPEAN PATENT APPLICATION

(11) **EP 2 088 445 A1**
(43) Date of publication of application: **12.08.2009**
(21) Application number: 07832000.9
(22) Date of filing: 16.11.2007
(51) Int. Cl.: G01R 31/36

(54) **ACCUMULATOR FAILURE DETECTING DEVICE, ACCUMULATOR FAILURE DETECTING METHOD, ACCUMULATOR FAILURE DETECTING PROGRAM, AND COMPUTER-READABLE RECORDING MEDIUM CONTAINING THE ACCUMULATOR FAILURE DETECTING PROGRAM**

(30) Priority: 27.11.2006 JP 2006318151
(71) Applicant: Panasonic Corporation, Kadoma-shi Osaka 571-8501 (JP)
(72) Inventor: IIDA, Takuma, Osaka-shi, Osaka 540-6207 (JP)
(74) Representative: Schwabe - Sandmair - Marx
(86) International application number: PCT/JP2007/072270
(87) International publication number: WO 2008/065910

(57) **Abstract**

A device detects a failure in an accumulator formed by connecting a plurality of accumulation portions including at least one accumulation element. Upon determining that the accumulator is in a state close to a failure state from a time interval between equalization processes on the plurality of accumulation portions, the device calculates a failure determination value from a charge and discharge capacity of the accumulator measured after the determination and makes a determination as to whether the accumulator is in a failure state using the failure determination value.

## Description

### Technical Field

The present invention relates to an accumulator failure detecting device, an accumulator failure detecting method, and an accumulator failure detecting program for detecting a failure in an accumulator incorporated into a power supply system as well as a computer-readable recording medium containing the accumulator failure detecting program. More particularly, the invention relates to an accumulator failure detecting device, an accumulator failure detecting method, and an accumulator failure detecting program that improve accuracy of failure detection by starting a failure detection at the instant when the accumulator shows a sign of the occurrence of a failure as well as a computer-readable recording medium containing the accumulator failure detecting program.

### Background Art

Recently, an accumulator is combined with a power generator, for example, a solar cell, so as to be used as a power supply system in some cases. The power generator generates electric power using natural energy, such as sunlight, wind power, and hydraulic power. Such a power supply system formed by combining the accumulator improves energy efficiencies by storing surplus electric power in the accumulator and feeding electric power from the accumulator when electric power is necessary in a load device.

One example of such a power supply system can be a photovoltaic system. In the photovoltaic system, the accumulator is charged with surplus electric power when an amount of electric power generation by sunlight is more than an amount of electric power consumed by the load device. Conversely, when an amount of electric power generation is less than an amount of electric power consumed by the load device, electric power discharged from the accumulator is fed to the load device in order to compensate for a shortfall of electric power. In this manner, owing to the ability to store surplus electric power that has not been conventionally utilized in the accumulator, the photovoltaic system is able to enhance energy efficiencies in comparison with a conventional power supply system.

Also, in the photovoltaic system, the charge and discharge control is performed in such a manner that a remaining capacity (hereinafter, referred to as the SOC) indicating a state of charge of the accumulator will not be increased to 100% in order to charge the accumulator efficiently with surplus electric power and the SOC will not drop to 0 (zero) in order to feed electric power to the load device whenever necessary. More specifically, the accumulator is normally controlled in such a manner that the SOC varies in a range of 20 to 80%.

Such a principle is used also in a hybrid electric vehicle (hereinafter, abbreviated as HEV) using both the engine and the motor. In a case where power from the engine is larger than motive power needed for driving, the HEV drives the electric generator with surplus electric power to charge the accumulator. Meanwhile, the HEV charges the accumulator by using the motor as the electric generator during braking or deceleration of the vehicle.

Recently, attention has been paid to a load leveling power supply and a plug-in HEV that effectively utilize nighttime electric power. The load leveling power supply is a system that consumes less electric power. It stores electric power in the accumulator during nighttime hours when electricity charges are cheap and uses the stored electric power during daytime hours when electric power consumption reaches the peak. The purpose of this system is to maintain an amount of electric power generation constant by leveling an amount of electric power consumption, so that a contribution can be made to efficient operation of power equipment and a reduction of capital investment.

On the contrary, the plug-in HEV uses nighttime electric power. When the HEV runs in an urban area where fuel efficiency is poor, it is mainly driven by EV driving in which electric power is fed from the accumulator whereas it is driven by HEV driving by which the engine and the motor are used when it runs over a long distance. The purpose of the plug-in HEV is to reduce a total amount of CO₂ emission.

Incidentally, the accumulator incorporated in the power supply system described above or the like is formed by connecting a plurality of accumulation elements (electric cells, unit batteries, etc.) in series. In the accumulator formed in this manner, a capacity can vary from one accumulation element to another. In this case, when the accumulator is discharged deeply at a large current, an accumulation element having a small capacity is over-discharged in comparison with other accumulation elements. Consequently, the over-discharged accumulation element deteriorates, which shortens the life of the accumulator as a whole.

In order to suppress such deterioration of the life of the accumulator, when a variance in capacity occurs, the accumulator is normally controlled so as to eliminate a variance in capacity using equalization means. However, when the accumulator deteriorates, the capacity is reduced, which causes the internal resistance to rise. Accordingly, even when the capacities are made equal through equalization, a voltage drop becomes larger due to the rising internal resistance when a large current is flown, and the voltage readily reaches the lower limit. Deterioration of the accumulator is thus accelerated and the safety of the battery is degraded. It is therefore crucial to detect deterioration of the accumulator precisely at an early stage and the following methods are proposed as the detection method.

For example, Patent Document 1 discloses, as means for detecting deterioration of a battery, a method of discharging the battery by a predetermined amount after an equalization discharge process and determining deterioration of the battery on the basis of a voltage when the discharge ends. Also, Patent Document 2 discloses a method of counting an accumulated current consumption of a battery and determining that the life has expired when the count value reaches or exceeds a predetermined value. These determination methods as above, however, have the following inconveniences.

According to the method disclosed in Patent Document 1, because a predetermined amount of electric power is further discharged after the equalization discharge process, the state of charge of the accumulator is deteriorated further. This raises a problem that an amount of energy (service life) that can be fed to the load device is reduced, which degrades the convenience of the accumulator.

According to the method disclosed in Patent Document 2, because the accumulated current consumption of the battery is counted from the initial state of the battery, it is indeed possible to predict a failure state of the accumulation elements in average. However, a period until the accumulation elements go into a failure state depends largely on the environment of use and the status of use in general. Accordingly, in the accumulator formed of a plurality of accumulation elements, a variance of deterioration among the accumulation elements can have influences on the count value that has been counted since the initial state of the battery. It is therefore difficult to predict a failure state of the overall accumulator at high accuracy.
Patent Document 1: JP-A-2003-282156
Patent Document 2: JP-A-7-160972

### Disclosure of the Invention

An object of the invention is to provide an accumulator failure detecting device capable of ensuring the safety of an accumulator by detecting a failure in the accumulator precisely at an early stage.

An accumulator failure detecting device according to one aspect of the invention is a device that detects a failure in an accumulator formed by connecting a plurality of accumulation portions including at least one accumulation element, including: an equalization process portion that performs a process to make a variance in capacity or voltage among the plurality of accumulation portions equal more than once; an equalization process interval calculation portion that calculates, when the equalization process portion ends one equalization process, a time interval between another equalization process performed earlier than the one equalization process and the one equalization process; a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state; a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.

In the foregoing accumulator failure detecting device, a time interval from the preceding equalization process is calculated each time an equalization process performed by the equalization process portion ends. In a case where the time interval becomes shorter than a preset time, it is first determined that the accumulator is in a state close to the failure state. Then, only in a case where it is determined that the accumulator is in a state close to the failure state, whether the accumulator is in a complete failure state is determined in detail by measuring a charge and discharge capacity or the like of the accumulator. Hence, by constantly monitoring a failure state of the accumulator simply through calculation of a time interval at which the equalization processes are performed, it becomes possible to find a sign of the occurrence of a failure in the accumulator at an early stage. Further, in a case where it is determined that the accumulator is in a state close to the failure state, it becomes possible to detect a failure in the accumulator exactly by further performing a detailed failure determination.

In the foregoing accumulator failure detecting device, in particular, a detailed failure determination is performed using a measurement value, such as a charge and discharge capacity, of the accumulator after it is determined that the accumulator is in a state close to a failure on the basis of the time interval of the equalization processes. Accordingly, it becomes possible to improve accuracy of the determination in comparison with a case where a determination is made using a value measured since the initial state where no failure is occurring in the accumulator.

### Brief Description of the Drawings

Fig. 1 is a view showing the configuration of a power supply system provided with an accumulator failure detecting device according to a first embodiment of the invention.
Fig. 2A is a view showing the configuration of a failure determination process portion of Fig. 1 and Fig. 2B is a view used to describe a reference value file of Fig. 2A.
Fig. 3 is a view showing the configuration of a control portion according to the first embodiment of the invention.
Fig. 4 is a flowchart (part 1) depicting the process procedure of an accumulator failure detecting method according to the first embodiment of the invention.
Fig. 5 is a flowchart (part 2) depicting the process procedure of the accumulator failure detecting method according to the first embodiment of the invention.
Fig. 6 is a view showing the configuration of a control portion according to a second embodiment of the invention.
Fig. 7 is a view used to describe a count value calculation information file of Fig. 6.
Fig. 8 is a flowchart depicting the process procedure of an accumulator failure detecting method according to the second embodiment of the invention.

### Best Mode for Carrying Out the Invention

Hereinafter, embodiments of the invention will be described with reference to the drawings. Same components or similar components are labeled with same or similar reference numerals in these drawings and descriptions of such components are omitted in the following where appropriate.

### First Embodiment

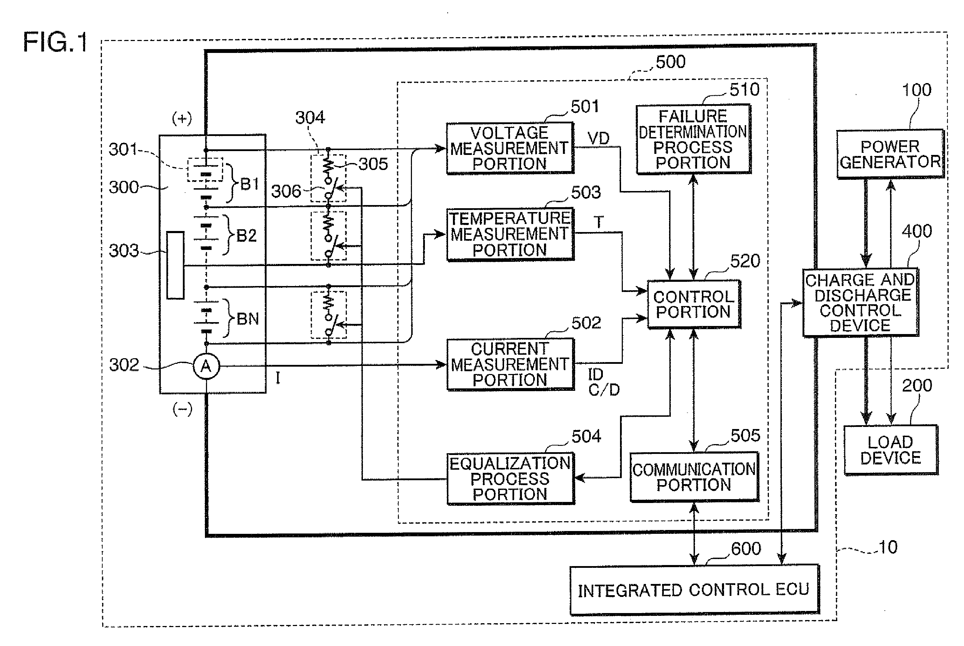

Fig. 1 is a view showing the configuration of a power supply system equipped with an accumulator failure detecting device according to a first embodiment of the invention. Referring to Fig. 1, a power supply system 10 according to the first embodiment of the invention includes a power generator 100 that generates electric power from natural energy, such as sunlight, wind power, and hydraulic power, an accumulator 300 that stores surplus electric power from the power generator 100 and feeds the stored electric power as needed to a load device 200 driven by a supply of electric power, a charge and discharge control device 400 that controls charge and discharge of the accumulator 300, a failure detecting device 500 that performs a failure detection process described below on the accumulator 300, and an integrated control ECU (Electric Control Unit) 600 that is connected to both the failure detecting device 500 and the charge and discharge control device 400 and controls the overall power supply system 10.

The power generator 100 is a power generator that utilizes natural energy, for example, a photovoltaic unit (solar cell), a wind power generation unit, and a hydraulic power generation unit. It also includes an electric generator using an engine as a power source. The load device 200 includes various loads driven by a supply of electric power. Besides known devices, a hydrogen station that utilizes power generation by natural energy and an electric generator (for example, a fuel cell) is also available.

The accumulator 300 is formed by connecting N accumulation element blocks B1, B2, ..., and BN in series. Also, each of the accumulation element blocks B1, B2, ..., and BN is formed by electrically connecting a plurality of accumulation elements 301 in series. As each accumulation element 301, an alkaline storage battery, such as a nickel hydride battery, an organic battery, such as a lithium-ion battery, and an electric double layer capacitor can be used. The number of accumulation element blocks, N, and the number of accumulation elements 301 included in each accumulation element block are not particularly limited. The accumulator 300 is not limited to the configuration of Fig. 1, either.

The charge and discharge control device 400 is connected to each of the power generator 100, the load device 200, and the accumulator 300, and controls charge from the power generator 100 to the accumulator 300 and discharge from the accumulator 300 to the load device 200. The charge and discharge control device 400 controls the accumulator 300 to be charged with a surplus of electric power outputted from the power generator 100 for the load device 200. On the contrary, in a case where electric power required by the load device 200 exceeds an amount of electric power generation by the power generator 100 due to an abrupt increase of a current consumed by the load device 200 or a decrease of an amount of electric power generation by the power generator 100, the charge and discharge control device 400 controls the accumulator 300 to discharge electric power comparable to a shortage to the load device 200.

The charge and discharge control by the charge and discharge control device 400 is normally performed in such a manner that the SOC of the accumulator 300 falls within a range of 20 to 80%. It should be noted, however, that the load leveling power supply, the plug-in HEV, and the like that effectively utilize nighttime electric power are controlled in such a manner that the accumulator 300 is charged to a state where the SOC is 100% and discharged when the load device 200 requires energy.

The failure detecting device 500 according to the first embodiment of the invention will now be described using Fig. 1. Referring to Fig. 1, the failure detecting device 500 includes a voltage measurement portion 501 that measures a voltage value of the accumulator 300, a current measurement portion 502 that measures a current value of the accumulator 300, a temperature measurement portion 503 that measures a temperature of the accumulator 300, an equalization process portion 504 that performs a process to make a variance in capacity or voltage among the accumulation element blocks B1, B2, ..., and BN forming the accumulator 300 equal, a failure determination process portion 510 that performs a failure determination process on the accumulation element blocks B1, B2, ..., and BN forming the accumulator 300, a communication portion 505 that makes communications with the integrated control ECU 600, and a control portion 520 that controls the respective portions within the failure detecting device 500.

The voltage measurement portion 501 measures voltages V0, V1, V2, ..., VN - 1, and VN across the terminals of the respective N accumulation element blocks B1, B2, ..., and BN forming the accumulator 300 in predetermined cycles in time series. It converts the measured voltage across the terminals of each accumulation element block that is now in the form of an analog signal to a digital signal, and outputs data of the voltage across the terminals of each block and the additional value thereof as voltage data VD of the accumulator 300. The data is outputted from the voltage measurement portion 501 to the control portion 520 in predetermined cycles. For example, a flying capacitor method is known as a method of measuring a voltage across the terminals of each accumulation element block in time series.

The current measurement portion 502 measures a charge and discharge current I of the accumulator 300 using a current sensor 302 in predetermined cycles. It converts the measured charge and discharge current I that is now in the form of an analog signal to a digital signal and outputs the digital signal as current data ID together with a sign, C(charge)/D(discharge), indicating a charge direction (+)/discharge direction (-), respectively. As with the data outputted from the voltage measurement portion 501, the data is also outputted from the current measurement portion 502 to the control portion 520 in predetermined cycles. Herein, the current sensor 302 is formed of a resistance element, a current transformer, or the like.

The temperature measurement portion 503 measures an internal temperature of the accumulator 300 in predetermined cycles using a temperature sensor 303 disposed inside the accumulator 300. It converts the measured temperature that is now in the form of an analog signal to a digital signal and outputs the digital signal as temperature data T to the control portion 520 in predetermined cycles.

The control portion 520 adds up the current data ID outputted from the current measurement portion 502 in a predetermined period (for example, a period no longer than a day) to calculate an integrated capacity Q. During this add up operation, in a case where the sign, C/D, received with the current data ID indicates the charge direction (+), the current data ID is multiplied by a charge efficiency (a coefficient smaller than 1, for example, 0.8). The control portion 520 predicts a remaining capacity, SOC, using the integrated capacity Q and stores the predicted SOC.

Herein, the SOC is found using the integrated capacity Q as described above. The present embodiment, however, is not limited to this configuration. For example, a plurality of pairs of data, each pair being made up of the voltage data VD and the current data ID, may be acquired in terms of the charge direction (+) and the discharge direction (-) to approximate these pairs of data to a straight line (VD-ID straight line), so that a no-load voltage Vo is found from a voltage intercept of the approximated straight line. Then, the SOC can be found by referring to an electromotive force versus SOC characteristic table, which is empirically found in advance, using, as an index, an electromotive force Vemf obtained by subtracting a voltage drop caused by an internal resistance and polarization components of the accumulator 300 from the no-load voltage Vo. Further, in an application where the temperature of the accumulator 300 varies considerably, the temperature data T outputted from the temperature measurement portion 503 can be used as a correction parameter for the electromotive force versus SOC characteristic table.

In a case where the voltages V0, V1, V2, ..., VN -1, and VN across the terminals of the accumulation element blocks B1, B2, ..., BN forming the accumulator 300 vary considerably, the equalization process portion 504 performs an equalization process on the accumulation element blocks B1, B2, ..., BN forming the accumulator 300 according to a command from the control portion 520. Herein, in a case where a variance of voltages across the terminals among the accumulation element blocks becomes larger, the equalization process portion 504 makes voltages across the terminals of the accumulation element blocks equal. Alternatively, in a case where a variance in capacity among the accumulator element blocks becomes larger, the capacities of the accumulator element blocks may be made equal.

Herein, the equalization process by the equalization process portion 504 will be described. As is shown in Fig. 1, a discharge circuit 304 is connected to the both terminals of each of the accumulation element blocks B1, B2, ..., and BN forming the accumulator 300. Each discharge circuit 304 is formed of a resistor 305 and a switch 306, and each switch 306 is controlled to open and close by the equalization process portion 504.

The control portion 520 finds the maximum voltage value and the minimum voltage value among the voltages across the terminals of the respective accumulation element blocks B1, B2, ..., and BN and further calculates a voltage difference. In a case where a predetermined amount of the voltage difference is occurring, it sets the minimum voltage value as a target voltage value. The equalization process portion 504 calculates discharge times corresponding to differences between the target voltage value and the voltages across the terminals of the respective accumulation element blocks B1, B2, ..., and BN. It then turns the respective discharge circuits 304 to an ON state by closing the switches 306 of the discharge circuits 304 of the respective accumulation elements B1, B2, ..., and BN for the discharge times that have been found. This allows an accumulation element block having a voltage across the terminals larger than the target voltage value to perform constant-resistance discharge using the resistor 305. The equalization process portion 504 performs the discharge of the respective blocks while monitoring the voltages across the terminals of the respective accumulation element blocks, and to this end, it has an internal timer capable of measuring the monitoring time.

The foregoing equalization process uses constant-resistance discharge. It may, however, be a process using variable resistance. It goes without saying that the equalization may be performed conversely by charging the respective accumulation element blocks to a predetermined voltage.

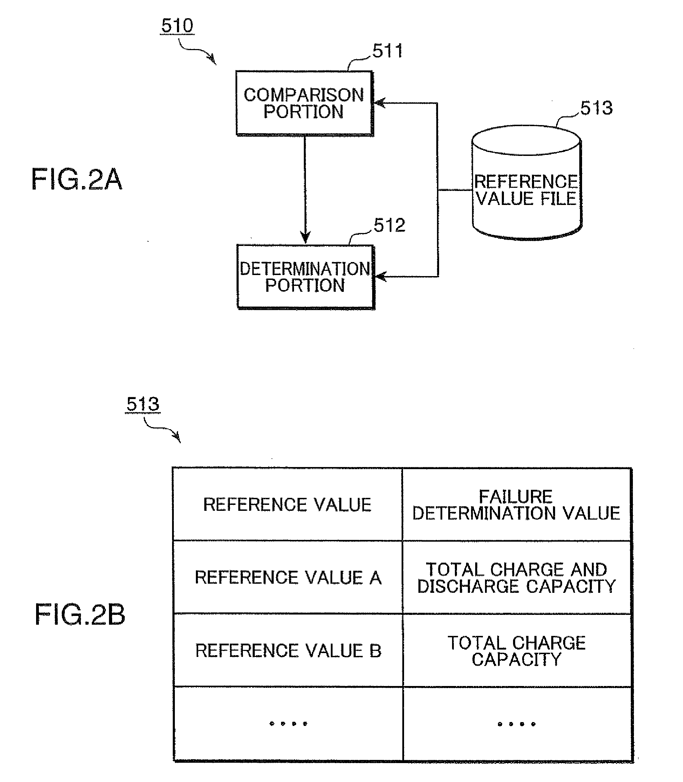

The failure determination process portion 510 in the failure detecting device 500 will now be described. Fig. 2A is a view showing the configuration of the failure determination process portion 510 and Fig. 2B is a view used to describe a reference value file 513 of Fig. 2A. As is shown in Fig. 2A, the failure determination process portion 510 is formed of a comparison portion 511 that compares a failure determination value from the control portion 520 with a predetermined reference value, a determination portion 512 that determines a failure in the accumulator 300 from the comparison result of the comparison portion 511 and outputs the determination result to the control portion 520, and the reference value file 513 connected to both the comparison portion 511 and the determination portion 512 and including a plurality of failure determination values and a plurality of reference values corresponding to the respective failure determination values. As is shown in Fig. 2B, in the reference value file 513, the reference values (reference value A, reference value B, and so on) and the failure determination values (a total charge and discharge capacity, a total charge capacity, and so on) are correlated with each other and the reference value is selected according to the failure determination value from the control portion 520.

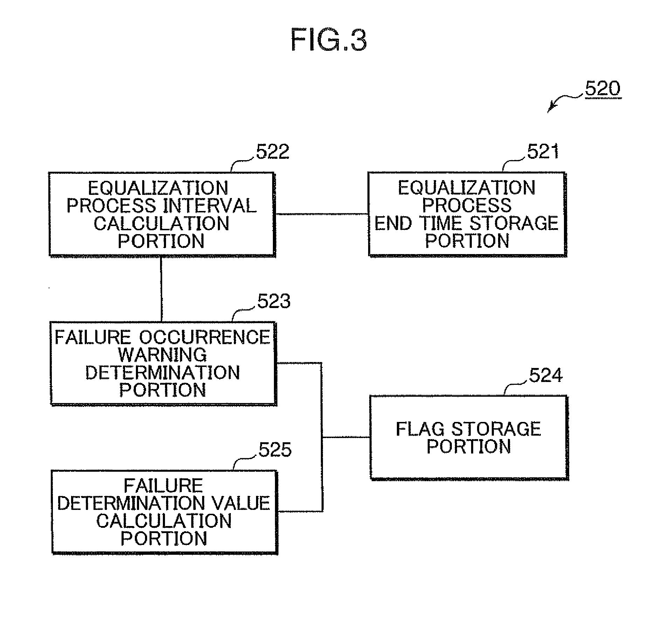

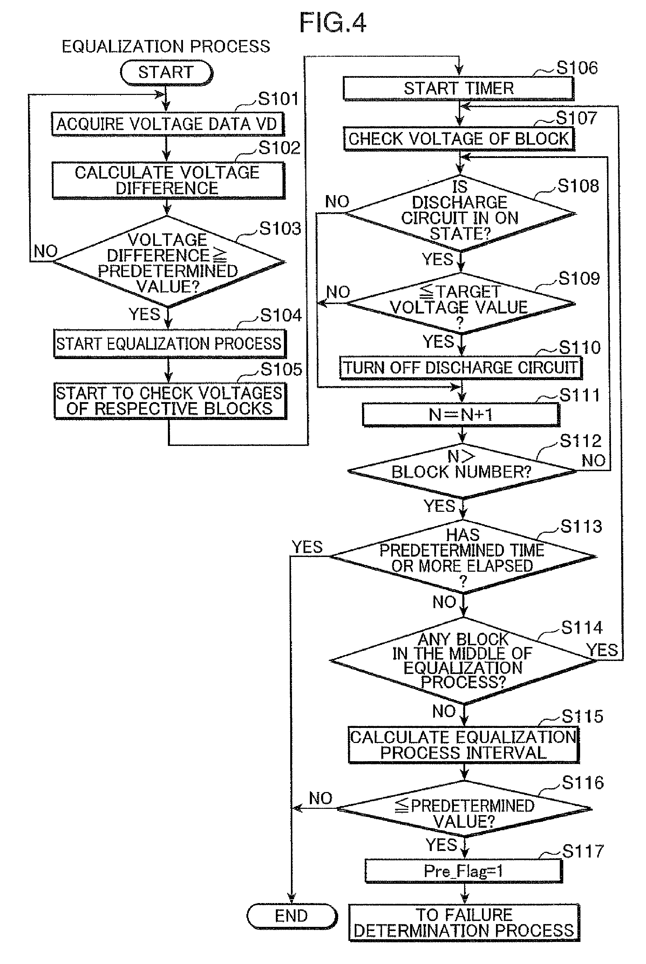

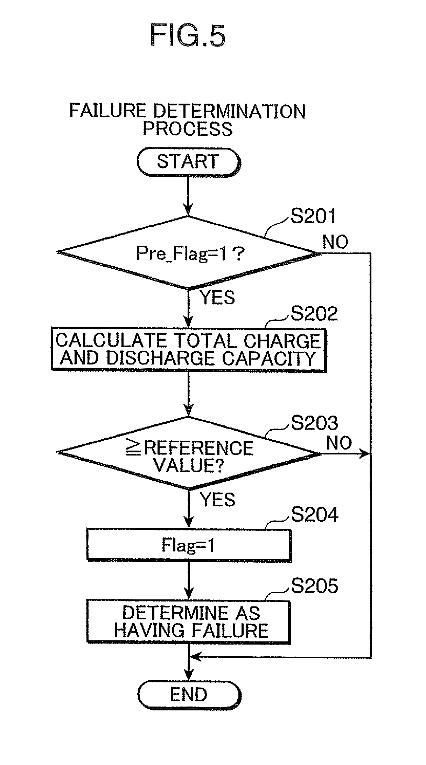

An operation of the failure detecting device, that is, an accumulator failure detecting method according to the first embodiment of the invention will now be described. Fig. 3 is a view showing the configuration provided to the control portion 520 in order to achieve the failure detecting method of the present embodiment. Fig. 4 and Fig. 5 are flowcharts depicting the process procedure of the failure detecting method of the present embodiment. Fig. 4 is a flowchart depicting the procedure of an equalization process on the accumulator performed by the control portion 520 and the equalization process portion 504. Fig. 5 is a flowchart depicting the procedure of a failure determination process on the accumulator performed by the control portion 520 and the failure determination process portion 510. The failure detecting method of the present embodiment is to perform the equalization process of Fig. 4 first and thence to perform the failure determination process of Fig. 5.

Firstly, the configuration of the control portion 520 will be described using Fig. 3. As has been described, the control portion 520 controls the respective portions in the failure detecting device 500 and includes, for example, the following configuration in order to perform the equalization process and the failure determination process described below. More specifically, as is shown in Fig. 3, the control portion 520 includes an equalization process end time storage portion 521 that stores an end time each time the equalization process on the accumulator 300 ends, an equalization process interval calculation portion 522 that calculates a performance interval of the equalization process from respective end times stored in the equalization process end time storage portion 521, a failure occurrence warning determination portion 523 that determines whether there is a sign of the occurrence of a failure in the accumulator 300 from the calculation result of the equalization process interval calculation portion 522, a flag storage portion 524 that sets up a preceding flag (Pre_Flag) in a case where the failure occurrence warning determination portion 523 determines that there is a sign of the occurrence of a failure so that the set up flag (Pre_Flag=1) indicates a failure occurrence warning, and a failure determination value calculation portion 525 that calculates the failure determination value used in the failure determination process on the basis of the current data ID and the temperature data T acquired from the current measurement portion 502 and the temperature measurement portion 503 of Fig. 1, respectively, when the preceding flag is set up in the flag storage portion 524.

The procedure of the equalization process on the accumulator 300 will now be described using Fig. 3 and Fig. 4. As is shown in Fig. 4, the control portion 520 acquires the voltage data VD containing voltages across the terminals of the respective accumulation element blocks B1, B2, ..., and BN forming the accumulator 300 from the voltage measurement portion 501 in time series (Step S101). The control portion 520 then finds the maximum voltage value and the minimum voltage value in the voltages across the terminals of the respective accumulation element blocks B1, B2, ..., and BN from the acquired voltage data VD and calculates a voltage difference between the maximum voltage value and the minimum voltage value that have been found (Step S102). It determines whether the voltage difference is equal to or larger than a predetermined value (Step S103). In a case where the voltage difference is smaller than the predetermined value (NO in Step S103), the flow returns to Step S101.

In a case where the voltage difference calculated in Step S102 is equal to or larger than the predetermined value (YES in Step S103), the control portion 520 sets the minimum voltage value found in Step S 102 as the target voltage value and issues a command to the equalization process portion 504 to start the equalization process. Upon receipt of the command, the equalization process portion 504 starts the equalization process by discharging all the accumulation element blocks except for an accumulation element block having the minimum voltage across the terminals. When the equalization process portion 504 starts the equalization process, it turns ON the discharge circuits 304 in the respective accumulation element blocks subjected to the equalization process (Step S104).

After the equalization process is started, the equalization process portion 504 starts to check the voltages across the terminals of the respective accumulation element blocks (Step S105) and starts the internal timer at the same time (Step S106). Subsequently, the equalization process portion 504 starts to check the voltage across the terminals, for example, from the accumulation element block B1 (count number N = 1) of Fig. 1 (Step S107).

In a case where the discharge circuit 304 of the accumulation element block B 1 is in an ON state (YES in Step S108), the equalization process portion 504 determines whether the voltage across the terminals of the accumulation element block B 1 is equal to or smaller than the target voltage value (Step S109). In a case where the voltage across the terminals of the accumulation element block B1 is equal to or smaller than the target voltage value (YES in Step S109), the equalization process portion 504 turns OFF the discharge circuit 304 of the block B 1 and ends the discharge from the block B1 (Step S110).

In a case where the discharge circuit of the block B1 is still in an OFF state in Step S108 after the discharge circuit 304 of the accumulation element block B1 is turned OFF in Step S 110 (NO in Step S108) and in a case where the voltage across the terminals of the block B 1 exceeds the target value in Step S109 (NO in Step S109), the equalization process portion 504 increments the count number N by one (Step S111) and determines whether the incremented count number N has exceeded the number of the accumulation element blocks of Fig. 1 (Step S112). In a case where the count number N has not exceeded a total number of blocks (NO in Step S112), the flow returns to again to Step S108 and Step S108 through Step S112 are repeated.

In a case where the count number N has exceeded a total number of blocks in Step S112 (YES in Step S112), the equalization process portion 504 determines whether a measurement time of the internal timer started in Step S106 is over a predetermined time (Step S 113) and ends the equalization process in a case where the predetermined time has already elapsed (YES in Step S113).

In a case where it is determined that the predetermined time has not elapsed in Step S113 (NO in Step S113), when there is an accumulation element block in the middle of the equalization process with its discharge circuit 304 being in an ON state among the accumulation element blocks subjected to the equalization process (YES in Step S114), the flow returns again to Step S107 and Step S 107 through Step S 114 are repeated starting with the counter number N = 1.

Meanwhile, in a case where all the discharge circuits 304 are in an OFF state and there is no accumulation element block in the middle of the equalization process (NO in Step S 114), the control portion 520 stores the end time of the equalization process in the equalization process end time storage portion 521 and the equalization process interval calculation portion 522 calculates the interval from the end time of the last equalization process (equalization process interval) (Step S 115).

The failure occurrence warning determination portion 523 determines whether the equalization process interval calculated in Step S 115 is equal to or smaller than a predetermined value by comparison and in a case where the equalization process interval is equal to or smaller than the predetermined value (YES in Step S116), it determines that there is a sign of the occurrence of a failure in the accumulator 300 and the preceding flag (Pre_Flag) is set up (Pre_Flag=1) in the flag storage portion 524 (Step S117). Meanwhile, in a case where the equalization process interval has exceeded the predetermined value (NO in Step S116), the failure occurrence warning determination portion 523 determines that there is no sign of the occurrence of a failure in the accumulator 300 and ends the process. In a case where the preceding flag is set up in Step S 117, the flow proceeds to the failure determination process of Fig. 5.

The procedure of the failure determination process on the accumulator 300 will now be described using Fig. 3 and Fig. 5. As is shown in Fig. 5, when the preceding flag (Pre_Flag) is set up (Pre_Flag=1) (Yes in Step S201), it means that there is a sign of the occurrence of a failure in the accumulator 300, that is, a failure occurrence waning is given to inform that the accumulator 300 is in "a state close to a failure state". The failure determination process is thus started according to the failure occurrence warning.

When the preceding flag is set up in the flag storage portion 524, the failure determination value calculation portion 525 in the control portion 520 calculates the failure determination value used in the failure determination process by the failure determination process portion 510. In the present embodiment, the failure determination value calculation portion 525 adds up the absolute value of a current value charged to and discharged from the accumulator 300, for example, in a predetermined period using the current data ID from the current measurement portion 502 and a calculates a sum (a total change and discharge capacity) as the failure determination value (Step S202).

Herein, a crucial point is that the failure determination value calculation portion 525 calculates a total charge and discharge capacity using the current data ID of the accumulator 300 measured after the preceding flag is set up. More specifically, in the present embodiment, the starting point of the calculation is set at a point in time when the accumulator 300 nears a failure state and a total charge and discharge capacity of the accumulator 300 measured after the starting point of the calculation is used as the failure determination value. Hence, different from a case where the current data ID measured since the initial state of the accumulator 300 is used, there will be no influences of a variance of deterioration among the accumulation elements 301 forming the accumulator 300. It thus becomes possible to perform the failure detection on the accumulator 300 at a higher degree of accuracy.

Referring to Fig. 5 again, a total charge and discharge capacity of the accumulator 300 calculated in Step S202 is outputted to the failure determination process portion 510 from the control portion 520 and the comparison portion 511 in the failure determination process portion 510 compares a total charge and discharge capacity of the accumulator 300 with a predetermined reference value in the reference value file 513 (Step S203). Herein, in order to make a comparison with a total charge and discharge capacity of the accumulator 300, for example, as is shown in Fig. 2B, the comparison portion 511 selects the reference value A in the reference value file 513. When a total charge and discharge capacity is smaller than the reference value A (NO in Step S203), the failure determination process portion 510 ends the failure determination process.

In a case where a total charge and discharge capacity is equal to or larger than the reference value A in Step S203 (YES in Step S203), the determination portion 512 in the failure determination process portion 510 determines from the comparison result that the accumulator 300 has shifted to "a complete failure state" from "a state close to a failure state". The failure determination process portion 510 outputs the determination result to the control portion 520 and the control device 520 sets up the flag in the flag storage portion 524 (Step S204). It notifies the integrated control ECU 600 that the accumulator 300 is in "a complete failure state" using the communication portion 505 (Step S205) and ends the failure determination process.

As has been described, according to the first embodiment of the invention, whether the accumulator 300 is in "a state close to a failure state" is determined first and a detailed failure determination is performed only when it is determined that the accumulator 300 is in "a state close to a failure state". Accordingly, a total charge and discharge capacity of the accumulator 300 after the accumulator 300 has shifted to "a state close to a failure state" is used as the failure determination value. It thus becomes possible to perform the failure detection on the accumulator at high accuracy without influences of a variance of deterioration among the accumulation elements 301 forming the accumulator 300.

In the present embodiment, the absolute value of a current value charged to and discharged from the accumulator 300 within a predetermined period after the preceding flag is set up in Step S202 of Fig. 5 is added up, and a sum (a total charge and discharge capacity) is calculated as the failure determination value. The invention, however, is not limited to this configuration. For example, the absolute value of a charge and discharge capacity charged to and discharged from the accumulator 300 until the end time of the current equalization process from the end time of the last equalization process may have been added up and the integrated value at a later time may be added only when the preceding flag is set up.

Also, in the present embodiment, the failure determination value calculated by the failure determination value calculation portion 525 in the control portion 520 is a sum of the charge and discharge capacities. However, a sum of charged currents or a sum of discharged currents of the accumulator 300 may be used as the failure determination value as well.

Further, in the present embodiment, by correcting the failure determination value calculated by the failure determination value calculation portion 525 and the reference values in the reference value file 513 using, for example, the temperature or a current value of charge and discharge of the accumulator 300, the failure determination value and the reference value can be more precise.

In the present embodiment, when the interval of the equalization processes is calculated, an interval from the last equalization process is used. However, an interval is not necessarily an interval from the successive last equalization process. As long as the equalization processes have been already performed, the interval can be an interval from the second or third equalization process from the last.

Further, the failure detecting method of the present embodiment may be achieved by running a program on a micro computer. More specifically, a failure detecting program to achieve the respective process steps depicted in Fig. 4 and Fig. 5 is installed in a micro computer and the failure detecting method can be achieved by running the failure detecting program thereon.

The failure detecting method by the failure detecting device 500 can be achieved by reading the accumulator failure detecting program using the micro computer and running the program thereon. To this end, it is sufficient to install the program in the memory portion of the micro computer and run the program on a CPU (Central Processing Unit) in the micro computer.

Also, it is possible to furnish the charge and discharge control device 400 of Fig. 1 with the capability of the failure detecting device 500. In this case, for example, the failure detecting program may be installed in the micro computer forming the charge and discharge control device 400 to run the program thereon. It goes without saying that the capability of the charge and discharge control device 400 may be furnished to the failure detecting device 500. Further, the capability of the failure detecting device 500 may be furnished to the load device 200 of Fig. 1.

### Second Embodiment

A second embodiment of the invention will now be described. The failure detecting method of the first embodiment above uses a total charge and discharge capacity of the accumulator 300 as the failure determination value used in the failure determination process in Step S202 of the failure determination process of Fig. 5. By contrast, in the present embodiment, an integrated count value of a charge and discharge current of the accumulator 300 is used as the failure determination value.

Hereinafter, the failure detecting method according to the second embodiment of the invention will be described. The equalization process in the failure detecting method of the present embodiment is the same as that in the first embodiment above. Accordingly, the failure determination process after the end of the equalization process will be described in the following.

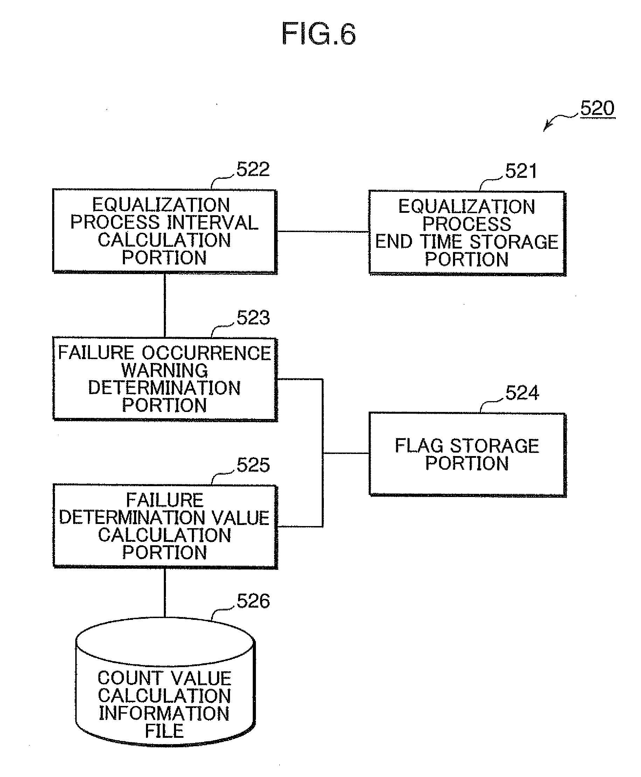

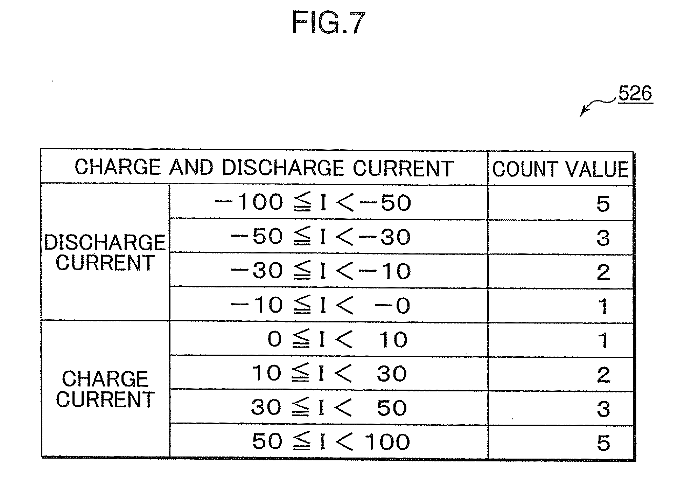

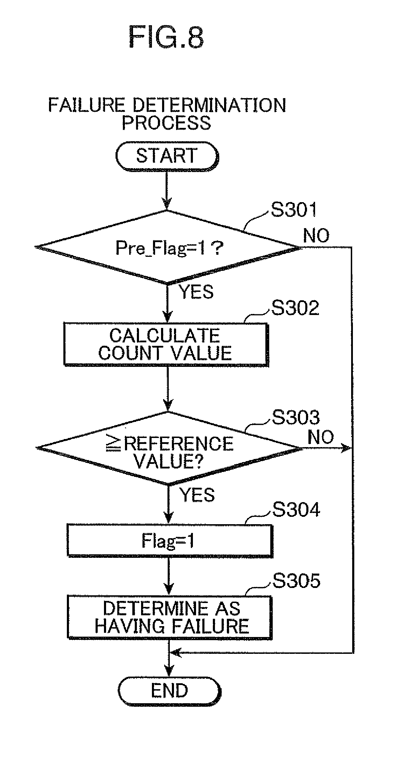

Fig. 6 is a view showing the configuration provided to the control portion 520 to achieve the failure detecting method of the present embodiment. Fig. 7 is a view used to describe the contents in a count value calculation information file 526 of Fig. 6. Fig. 8 is a flowchart depicting the procedure of the failure determination process on the accumulator performed by the control portion 520 and the failure determination process portion 510.

Firstly, the configuration of the control portion 520 of the second embodiment will be described using Fig. 6. The control portion 520 includes an equalization process end time storage portion 521 that stores an end time each time the equalization process on the accumulator 300 ends, an equalization process interval calculation portion 522 that calculates a performance interval of the equalization process from respective end times stored in the equalization process end time storage portion 521, a failure occurrence warning determination portion 523 that determines whether there is a sign of the occurrence of a failure in the accumulator 300 from the calculation result of the equalization process interval calculation portion 522, a flag storage portion 524 that sets up a preceding flag (Pre_Flag) in a case where the failure occurrence warning determination portion 523 determines that there is a sign of the occurrence of a failure so that the set up flag (Pre_Flag=1) indicates a failure occurrence warning, and a failure determination value calculation portion 525 that calculates a failure determination value used in the failure determination process on the basis of the current data ID and the temperature data T acquired from the current measurement portion 502 and the temperature measurement portion 503 of Fig. 1, respectively, when the preceding flat is set up in the flag storage portion 524.

The configuration up to this point is the same as that of the control portion 520 of the first embodiment above in Fig. 3. It should be noted that the control portion 520 of the second embodiment in Fig. 6 further includes a count value calculation information file 526. The count value calculation information file 526 shows count values assigned to the respective average values when the failure determination value calculation portion 525 counts an average value of a charge and discharge current of the accumulator 300 in a predetermined period. In the count value calculation information file 526, as is shown in Fig. 7, a plurality of ranges in which to include the respective average values are prepared and a count value is set for each range. When each average value is calculated, the failure determination value calculation portion 525 specifies a range in which the average value is included and obtains the count value set in this range. The failure determination value is calculated by adding up the count value obtained in this manner each time the average value is calculated.

The procedure of the failure determination process of the present embodiment will now be described. As is shown in Fig. 8, when the preceding flag (Pre_Flag) is set up (Pre Flag=1) (YES in Step S301), it is determined that there is a sign of the occurrence of a failure in the accumulator 300, that is, the accumulator 300 is in "a state close to a failure state", and the failure determination process is started.

When the preceding flag is set up in the flag storage portion 524, the failure determination value calculation portion 525 in the control portion 520 calculates the failure determination value used in the failure determination process by the failure determination process portion 510. In the present embodiment, it calculates an average value of a charge and discharge current in each predetermined period using the current data ID from the current measurement portion 502 to obtain the count value of each average value from the count value calculation information file 526, and adds up the obtained count value over a predetermined measuring time (Step S302).

The integrated count value of the accumulator 300 calculated in Step S302 is outputted to the failure determination process portion 510 from the control portion 520, and the comparison portion 511 in the failure determination process portion 510 compares the integrated count value of the accumulator 300 with a predetermined reference value in the reference value file 513 (Step S303). In a case where the integrated count value is smaller than the reference value (NO in Step S303), the failure determination process portion 510 ends the failure determination process.

In a case where the integrated count value is equal to or larger than the reference value in Step S303 (YES in Step S303), the determination portion 512 determines from the comparison result that the accumulator 300 has shifted from "a state close to a failure state" to "a complete failure state". The failure determination process portion 510 outputs the determination result to the control portion 520 and the control portion 520 sets up the flag in the storage portion 524 (Step S304). The failure determination process portion 510 then notifies the integrated control ECU 600 that the accumulator 300 is in "a complete failure state" using the communication portion 505 (Step S305) and ends the failure determination process.

As has been described, according to the second embodiment of the invention, a failure detection can be performed on the accumulator 300 using a current count value of a charge and discharge current of the accumulator 300 after the accumulator 300 has shifted to "a state close to a failure state". It thus becomes possible to achieve a failure detection on the accumulator at high accuracy without influences of a variance of deterioration among the accumulation elements 301 forming the accumulator 300.

Also, according to the present embodiment, an average value of a charge and discharge current is calculated at predetermined intervals and the count value thereof is added up. Hence, even when a large current flows, a current value at predetermined intervals can be made smaller by shortening its interval, which makes it possible to add up the count value precisely. Hence, by using the precise count value, it becomes possible to further improve accuracy of the failure detection.

In the present embodiment, the counting is performed on the basis of a current value of a charge and discharge current of the accumulator 300. However, the counting may be performed on the basis of the temperature of the accumulator 300 or on the basis of both the current value and the temperature.

In the present embodiment, an interval at which an average value of a charge and discharge current is calculated in Step S302 of Fig. 8 can be, for example, about one second. It goes without saying that the interval can be set to suit the environment of use and the status of the accumulator 300.

Also, in the present embodiment, by correcting the failure determination value calculated by the failure determination value calculation portion 525 and the reference values in the reference value file 513 using the temperature or the current value of a charge and discharge of the accumulator 300, the failure determination value and the reference values can be more precise.

From the respective embodiments described above, the invention can be summarized as follows. That is, an accumulator failure detecting device according to one aspect of the invention is a device that detects a failure in an accumulator formed by connecting a plurality of accumulation portions including at least one accumulation element, including: an equalization process portion that performs a process to make a variance in capacity or voltage among the plurality of accumulation portions equal more than once; an equalization process interval calculation portion that calculates, when the equalization process portion ends one equalization process, a time interval between another equalization process performed earlier than the one equalization process and the one equalization process that has just ended; a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state; a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition. The accumulation portions referred to herein mean, for example, the accumulation element blocks B1, B2, ..., and BN formed of at least one accumulation element as is shown in Fig. 1. It should be appreciated that the number and a manner of connections are not limited to those specified in the configuration of Fig. 1 and it is sufficient to include at least one accumulation element.

In the foregoing accumulator failure detecting device, a time interval from the preceding equalization process is calculated each time an equalization process performed by the equalization process portion ends. In a case where the time interval becomes shorter than a preset time, it is first determined that the accumulator is in a state close to the failure state. Then, only in a case where it is determined that the accumulator is in a state close to the failure state, whether the accumulator is in a complete failure state is determined in detail by measuring a charge and discharge capacity or the like of the accumulator. Hence, by constantly monitoring a failure state of the accumulator simply through calculation of a time interval at which the equalization processes are performed, it becomes possible to find a sign of the occurrence of a failure in the accumulator at an early stage. Further, in a case where it is determined that the accumulator is in a state close to the failure state, it becomes possible to detect a failure in the accumulator exactly by further performing a detailed failure determination.

In the foregoing accumulator failure detecting device, in particular, a detailed failure determination is performed using a measurement value, such as a charge and discharge capacity, of the accumulator after it is determined that the accumulator is in a state close to a failure on the basis of the time interval of the equalization processes. Accordingly, it becomes possible to improve accuracy of the determination in comparison with a case where a determination is made using a value measured since the initial state where no failure is occurring in the accumulator.

It is preferable to further include a storage portion that stores an end time of one equalization process each time the equalization process portion ends the equalization process, so that the equalization process interval calculation portion obtains, when the equalization process portion ends one equalization process, an end time of another equalization process performed earlier than the one equalization process from the storage portion and calculates a time elapsed since the end time of the another equalization process performed earlier.

According to this configuration, by managing the end time of one equalization process, it becomes possible to determine whether the accumulator is in a state close to the failure state at a point in time when the equalization process ends. Accordingly, in a case where it is determined that the accumulator is in a state close to the failure state, the device is able to swiftly shift to a following detailed failure determination.

It is preferable that the failure determination process portion includes: a reference value file that includes a plurality of reference values set correspondingly to types of failure determination values calculated by the failure determination value calculation portion; a comparison portion that receives an input of the failure determination value calculated by the failure determination value calculation portion to obtain a reference value corresponding to the inputted failure determination value from the reference value file and compares the obtained reference value with the inputted failure determination value; and a determination portion that makes a determination as to whether the inputted failure determination value satisfies the preset condition depending on whether the inputted failure determination value is equal to or larger than the obtained reference value.

According to this configuration, it becomes possible to determine whether the accumulator is in a failure state by merely comparing the failure determination value with the reference value corresponding to the type of the failure determination value. Consequently, a determination as to whether the accumulator is in the failure state can be performed at a high speed.

It is preferable that the failure determination value calculated by the failure determination value calculation portion is obtained by adding up an absolute value of a current value of a charge and discharge current of the accumulator after the failure occurrence warning determination portion makes a determination that the accumulator is in a state close to the failure state, and the failure determination process portion makes a determination as to whether the failure determination value satisfies the preset condition depending on whether a resulting integrated value is equal to or larger than a predetermined reference value.

According to this configuration, in a case where the failure determination value is calculated on the basis of a charge and discharge current of the accumulator, the absolute values of current values of a charge current and a discharge current are added up. It thus becomes possible to calculate a current value of a total charge and discharge current.

It is preferable that the failure determination value calculated by the failure determination value calculation portion is obtained by adding up a count value set for an average value of at least one of a charge and discharge current, a charge current, a discharge current, and a temperature of the accumulator in each predetermined period after the failure occurrence warning determination portion makes a determination that the accumulator is in a state close to the failure state, and the failure determination process portion makes a determination as to whether the failure determination value satisfies the preset condition depending on whether a resulting integrated value is equal to or larger than a predetermined reference value.

According to this configuration, an average value of a charge and discharge current or the like in each predetermined period is calculated and a count value set for each average value is added up. Accordingly, for example, even when a large current flows instantaneously, it is possible to suppress that considerable influences are given from such a large current, which can in turn makes it possible to add up the count value precisely.

It is preferable to further include a count value file having a plurality of ranges in any of which the average value of at least one of the charge and discharge current, the charge current, the discharge current, and the temperature of the accumulator in each predetermined period is to be included and a count value set for each of the plurality of ranges, so that the failure determination value calculation portion adds up the count value in a range in which the average value of at least one of the charge and discharge current, the charge current, the discharge current, and the temperature of the accumulator in each predetermined period is included.

According to this configuration, a range to include a value of each average value in each predetermined period is divided into a plurality of ranges and one count value is set in each divided range. Accordingly, the number of count values is equal to the number of the divided ranges. This configuration facilitates the management of the count values.

It is preferable that values of each of the failure determination value calculated by the failure determination value calculation portion and the reference value used by the failure determination process portion for a determination is corrected on the basis of at least one of a current value to be charged to or discharged from the accumulator, a state of charge of the accumulator, and a temperature of the accumulator measured after the failure occurrence warning determination portion makes a determination that the accumulator is in a state close to the failure state.

According to this configuration, it becomes possible to correct the failure determination value and the reference value to values that suit a state of charge of the accumulator, which can in tune improve accuracy of the failure determination.

An accumulator failure detecting method according to another aspect of the invention is a method of detecting a failure in an accumulator formed by connecting a plurality of accumulation portions including at least one accumulation element, including: a first step of performing a process to make a variance in capacity or voltage among the plurality of accumulation portions equal more than once; a second step of calculating, when one equalization process ends in the first step, a time interval between another equalization process performed earlier than the one equalization process and the one equalization process that has just ended; a third step of making a determination that the accumulator is in a state close to a failure state in a case where the time interval calculated in the second step becomes shorter than a preset time with which to determine that the accumulator is in a state closer to the failure state; a fourth step of calculating, in a case where the determination is made that the accumulator is in a state close to the failure state in the third step, a failure determination value using at least one of a charge and discharge capacity, a charge capacity, a discharge capacity, and a temperature of the accumulator measured after the determination; and a fifth step of making a determination as to whether the failure determination value calculated in the fourth step satisfies a preset condition under which to determine that the accumulator is in the failure state, and making a determination that the accumulator is in the failure state in a case where the failure determination value satisfies the preset condition.

In the foregoing accumulator failure detecting method, a time interval from the preceding equalization process is calculated each time an equalization process performed by the equalization process portion ends. In a case where the time interval becomes shorter than a preset time, it is first determined that the accumulator is in a state close to the failure state. Then, only in a case where it is determined that the accumulator is in a state close to the failure state, whether the accumulator is in a complete failure state is determined in detail by measuring a charge and discharge capacity or the like of the accumulator. Hence, by constantly monitoring a failure state of the accumulator simply through calculation of a time interval at which the equalization processes are performed, it becomes possible to find a sign of the occurrence of a failure in the accumulator at an early stage. Further, in a case where it is determined that the accumulator is in a state close to the failure state, it becomes possible to detect a failure in the accumulator exactly by further performing a detailed failure determination.

Also, in the foregoing accumulator failure detecting method, a detailed failure determination is performed using a measurement value, such as a charge and discharge capacity, of the accumulator after it is determined that the accumulator is in a state close to a failure on the basis of the time interval of the equalization processes. Accordingly, it becomes possible to improve accuracy of the determination in comparison with a case where a determination is made using a value measured since the initial state where no failure is occurring in the accumulator.

An accumulator failure detecting program according to still another aspect of the invention is a program that detects a failure in an accumulator formed by connecting a plurality of accumulation portions including at least one accumulation element, characterized by causing a computer to function as follows: an equalization process portion that requests a process to make a variance in capacity or voltage among the plurality of accumulation portions equal more than once; an equalization process interval calculation portion that calculates, when an end of one equalization process is notified, a time interval between another equalization process performed earlier than the one equalization process and the one equalization process that has been notified; a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state; a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.

In the foregoing accumulator failure detecting program, a time interval from the preceding equalization process is calculated each time an equalization process performed by the equalization process portion ends. In a case where the time interval becomes shorter than a preset time, it is first determined that the accumulator is in a state close to the failure state. Then, only in a case where it is determined that the accumulator is in a state close to the failure state, whether the accumulator is in a complete failure state is determined in detail by measuring a charge and discharge capacity or the like of the accumulator. Hence, by constantly monitoring a failure state of the accumulator simply through calculation of a time interval at which the equalization processes are performed, it becomes possible to find a sign of the occurrence of a failure in the accumulator at an early stage. Further, in a case where it is determined that the accumulator is in a state close to the failure state, it becomes possible to detect a failure in the accumulator exactly by further performing a detailed failure determination.

Also, in the foregoing accumulator failure detecting program, a detailed failure determination is performed using a measurement value, such as a charge and discharge capacity, of the accumulator after it is determined that the accumulator is in a state close to a failure on the basis of the time interval of the equalization processes. Accordingly, it becomes possible to improve accuracy of the determination in comparison with a case where a determination is made using a value measured since the initial state where no failure is occurring in the accumulator.

A computer-readable recording medium containing an accumulator failure detecting program according to still another aspect of the invention is a computer-readable recording medium having recorded a program for detecting a failure in an accumulator formed by connecting a plurality of accumulation portions including at least one accumulation element that causes a computer to function as follows: an equalization process portion that requests a process to make a variance in capacity or voltage among the plurality of accumulation portions equal more than once; an equalization process interval calculation portion that calculates, when an end of one equalization process is notified, a time interval between another equalization process performed earlier than the one equalization process and the one equalization process that has been notified; a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state; a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.

In the foregoing accumulator failure detecting program recorded in the recording medium, a time interval from the preceding equalization process is calculated each time an equalization process performed by the equalization process portion ends. In a case where the time interval becomes shorter than a preset time, it is first determined that the accumulator is in a state close to the failure state. Then, only in a case where it is determined that the accumulator is in a state close to the failure state, whether the accumulator is in a complete failure state is determined in detail by measuring a charge and discharge capacity or the like of the accumulator. Hence, by constantly monitoring a failure state of the accumulator simply through calculation of a time interval at which the equalization processes are performed, it becomes possible to find a sign of the occurrence of a failure in the accumulator at an early stage. Further, in a case where it is determined that the accumulator is in a state close to the failure state, it becomes possible to detect a failure in the accumulator exactly by further performing a detailed failure determination.

Also, in the foregoing accumulator failure detecting program recorded in the recording medium, a detailed failure determination is performed using a measurement value, such as a charge and discharge capacity, of the accumulator after it is determined that the accumulator is in a state close to a failure on the basis of the time interval of the equalization processes. Accordingly, it becomes possible to improve accuracy of the determination in comparison with a case where a determination is made using a value measured since the initial state where no failure is occurring in the accumulator.

### Industrial Applicability

The failure detecting device, the failure detecting method, and the failure detecting program for an accumulator as well as the computer-readable recording medium containing the failure detecting program are useful in a power supply and a device in which an equalization process is performed on the accumulator and therefore have an industrial applicability.

## Claims

1. An accumulator failure detecting device that detects a failure in an accumulator formed by connecting a plurality of accumulation portions including at least one accumulation element, **characterized by** comprising:
an equalization process portion that performs a process to make a variance in capacity or voltage among the plurality of accumulation portions equal more than once;
an equalization process interval calculation portion that calculates, when the equalization process portion ends one equalization process, a time interval between another equalization process performed earlier than the one equalization process and the one equalization process that has just ended;
a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state;
a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and
a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.

2. The accumulator failure detecting device according to claim 1, further comprising:
a storage portion that stores an end time of one equalization process each time the equalization process portion ends the equalization process,
wherein the equalization process interval calculation portion obtains, when the equalization process portion ends one equalization process, an end time of another equalization process performed earlier than the one equalization process from the storage portion and calculates a time elapsed since the end time of the another equalization process performed earlier.

3. The accumulator failure detecting device according to claim 1 or 2, wherein the failure determination process portion includes:
a reference value file that includes a plurality of reference values set correspondingly to types of failure determination values calculated by the failure determination value calculation portion;
a comparison portion that receives an input of the failure determination value calculated by the failure determination value calculation portion to obtain a reference value corresponding to the inputted failure determination value from the reference value file and compares the obtained reference value with the inputted failure determination value; and
a determination portion that makes a determination as to whether the inputted failure determination value satisfies the preset condition depending on whether the inputted failure determination value is equal to or larger than the obtained reference value.

4. The accumulator failure detecting device according to claim 1 or 2, wherein:
the failure determination value calculated by the failure determination value calculation portion is obtained by adding up an absolute value of a current value of a charge and discharge current of the accumulator after the failure occurrence warning determination portion makes a determination that the accumulator is in a state close to the failure state, and the failure determination process portion makes a determination as to whether the failure determination value satisfies the preset condition depending on whether a resulting integrated value is equal to or larger than a predetermined reference value.

5. The accumulator failure detecting device according to claim 1 or 2, wherein:
the failure determination value calculated by the failure determination value calculation portion is obtained by adding up a count value set for an average value of at least one of a charge and discharge current, a charge current, a discharge current, and a temperature of the accumulator in each predetermined period after the failure occurrence warning determination portion makes a determination that the accumulator is in a state close to the failure state, and the failure determination process portion makes a determination as to whether the failure determination value satisfies the preset condition depending on whether a resulting integrated value is equal to or larger than a predetermined reference value.

6. The accumulator failure detecting device according to claim 5, further comprising:
a count value file having a plurality of ranges in any of which the average value of at least one of the charge and discharge current, the charge current, the discharge current, and the temperature of the accumulator in each predetermined period is to be included and a count value set for each of the plurality of ranges,
wherein the failure determination value calculation portion adds up the count value in a range in which the average value of at least one of the charge and discharge current, the charge current, the discharge current, and the temperature of the accumulator in each predetermined period is included.

7. The accumulator failure detecting device according to claim 3, wherein:
values of each of the failure determination value calculated by the failure determination value calculation portion and the reference value used by the failure determination process portion for a determination is corrected on the basis of at least one of a current value to be charged to or discharged from the accumulator, a state of charge of the accumulator, and a temperature of the accumulator measured after the failure occurrence warning determination portion makes a determination that the accumulator is in a state close to the failure state.

8. An accumulator failure detecting method of detecting a failure in an accumulator formed by connecting a plurality of accumulation portions including at least one accumulation element, **characterized by** comprising:
a first step of performing a process to make a variance in capacity or voltage among the plurality of accumulation portions equal more than once;
a second step of calculating, when one equalization process ends in the first step, a time interval between another equalization process performed earlier than the one equalization process and the one equalization process that has just ended;
a third step of making a determination that the accumulator is in a state close to a failure state in a case where the time interval calculated in the second step becomes shorter than a preset time with which to determine that the accumulator is in a state closer to the failure state;
a fourth step of calculating, in a case where the determination is made that the accumulator is in a state close to the failure state in the third step, a failure determination value using at least one of a charge and discharge capacity, a charge capacity, a discharge capacity, and a temperature of the accumulator measured after the determination; and
a fifth step of making a determination as to whether the failure determination value calculated in the fourth step satisfies a preset condition under which to determine that the accumulator is in the failure state, and making a determination that the accumulator is in the failure state in a case where the failure determination value satisfies the preset condition.

9. An accumulator failure detecting program that detects a failure in an accumulator formed by connecting a plurality of accumulation portions including at least one accumulation element, **characterized by** causing a computer to function as follows:
an equalization process portion that requests a process to make a variance in capacity or voltage among the plurality of accumulation portions equal more than once;
an equalization process interval calculation portion that calculates, when an end of one equalization process is notified, a time interval between another equalization process performed earlier than the one equalization process and the one equalization process that has been notified;
a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state;
a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and
a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.

10. A computer-readable recording medium containing an accumulator failure detecting program for detecting a failure in an accumulator formed by connecting a plurality of accumulation portions including at least one accumulation element and **characterized by** causing a computer to function as follows:
an equalization process portion that requests a process to make a variance in capacity or voltage among the plurality of accumulation portions equal more than once;
an equalization process interval calculation portion that calculates, when an end of one equalization process is notified, a time interval between another equalization process performed earlier than the one equalization process and the one equalization process that has been notified;
a failure occurrence warning determination portion that makes a determination that the accumulator is in a state close to a failure state in a case where the time interval calculated by the equalization process interval calculation portion becomes shorter than a preset time with which to determine that the accumulator is in a state close to the failure state;
a failure determination value calculation portion that calculates, in a case where the failure occurrence warning determination portion makes a determination that the accumulator is in a state close to the failure state, a failure determination value using at least one of a charge and discharge capacity, a charge capacity, a discharge capacity, and a temperature of the accumulator measured after the determination; and
a failure determination process portion that makes a determination as to whether the failure determination value calculated by the failure determination value calculation portion satisfies a preset condition under which to determine that the accumulator is in the failure state, and makes a determination that the accumulator is in the failure state in a case where the failure determination value satisfies the preset condition.
